# EUROPÄISCHE PATENTANMELDUNG

(11) **EP 1 860 681 A1**
(43) Veröffentlichungstag der Anmeldung: **28.11.2007**
(21) Anmeldenummer: 07107687.1
(22) Anmeldetag: 08.05.2007
(51) Int. Cl.: H01J 37/34, C23C 14/46, C23C 14/34, C23C 14/54

(54) **Beschichtungsanlage sowie Verfahren zum Beschichten eines Substrats**

(30) Priorität: 23.05.2006 DE 102006024068
(71) Anmelder: Oerlikon Leybold Vacuum GmbH, 50968 Köln (DE)
(72) Erfinder: Reineck, Josef, 50678, Köln (DE)
(74) Vertreter: von Kirschbaum, Alexander

(57) **Zusammenfassung**

Eine Beschichtungsanlage zur Beschichtung eines Substrats (22) nach dem Ionen-Sputter-Verfaht-en, weist eine Vakuumkammer (10) auf, in der das zu beschichtende Substrat (22) angeordnet ist. Ferner ist in der Vakuumkammer (10) ein Halteelement (32) angeordnet, das Beschichtungselemente (16) trägt. Mit Hilfe einer Ionenquelle (12) wird ein Ionenstrahl (14) erzeugt, der auf das Beschichtungselement (16) trifft und somit durch Sputtern einen Beschichtungsmaterial-Strahl (18) erzeugt. Das Beschichtungsmaterial (18) lagert sich auf der Oberfläche des Substrats (22) ab. Zur Vergleichmäßigung der Dicke des Beschichtungsmaterials auf dem Substrat (22) ist das Halteelement (32) mit einer Schwenkeinrichtung (33) verbunden. Die Schwenkeinrichtung (33) ist mit einer Steuereinrichtung (35) zum Steuern eines Auslenkwinkels und/ oder einer Schwenkfrequenz verbunden.

## Beschreibung

Die Erfindung betrifft eine Beschichtungsanlage sowie ein Verfahren zur Beschichtung eines Substrats nach dem Ionen-Sputter-Verfahren.

Mit dem Ionen-Sputter-Verfahren werden Substrate wie opto-elektrische Bauteile beschichtet. Hierzu sind die zu beschichtenden Substrate in einer Vakuumkammer angeordnet. Mit Hilfe einer Ionenquelle wird ein Ionenstrahl erzeugt, der auf einem Beschichtungselement, ein sogenanntes Target trifft. Hierdurch erfolgt ein Materialabtrag. Durch den Ionenstrahl werden somit Bestandteile des Beschichtungselements herausgebrochen, das Beschichtungselement wird gesputtert. Hierdurch entsteht Beschichtungsmaterial das sich zur Beschichtung auf Grund des Impulses in Richtung des Substrats beweg. Das Material bildet hierbei eine Abstrahlkeule innerhalb der die Anzahl der Partikel des Beschichtungsmaterials eine unterschiedliche Dichte aufweisen. Ublicherweise sind die Partikel nach der Gaußchen-Glocke verteilt. Auf Grund der unregelmäßigen Verteilung des Beschichtungsmaterials wird eine entsprechend ungleichmäßig Schichtdicke auf dem Substrat erzeugt. Um eine gleichmäßiges Verteilen der Schichtdicke auf dem Substrat zu ermöglichen, ist es bekannt, schwenkbare Ionenquellen vorzusehen, um die Abstrahlrichtung des Beschichtungsmaterial-Strahls zu verändern. Dies ist technisch jedoch aufwendig. Eine weitere Möglichkeit besteht darin, das Substrat selbst zu verschieben. Auch hierfür ist jedoch eine zusätzliche Verschiebeeinrichtung, die ublicherweise einen Stellmotor aufweist, erforderlich.

Sofern Substrate mit unterschiedlichen Materialien beschichtet werden sollen und eine entsprechende Materialzusammensetzung nicht oder technologisch nur schwierig als Beschichtungselement bzw. Target aufgebaut werden kann, ist es erforderlich, dass Beschichtungselement auszuwechseln. Hierzu muss die Vakuumkammer geöffnet werden, um sodann ein neues Beschichtungselement in die Vakuumkammer einzusetzen. Dies ist zeitaufwendig und ferner kostenintensiv, da bevor eine weitere Beschichtung erfolgen kann, die Vakuumkammer zunächst wieder evakuiert werden muss. Ferner ist dies technologisch bedenklich. Durch die Belüftung kann der bestehende Film auf dem Substrat nicht mit Partnern (z. B. O₂) reagieren und/oder eine Verunreinigung auftreten.

Es ist bekannt, in der Vakuumkammer mehrere Beschichtungselemente vorzusehen, die verschiebbar angeordnet sind. Durch das Verschieben der einzelnen Beschichtungselemente werden diese in den Strahlengang des Ionenstrahls verschoben. Verschiebbare Beschichtungselemente haben jedoch den Nachteil, dass eine entsprechend größere Vakuumkammer vorgesehen sein muss, da verschiebbare Beschichtungselemente einen größeren Platzbedarf benötigen. Da die Vakuumkammer üblicherweise aus Edelstahl hergestellt ist, erhöhen sich hierdurch die Kosten der Beschichtungsanlage erheblich.

Aus EP 0 908 532 ist ferner eine Beschichtungsanlage bekannt, die innerhalb der Vakuumkammer ein Halteelement aufweist, das mehrere Beschichtungselemente trägt. Das Halteelement ist schwenkbar, um unterschiedliche Beschichtungselemente in dem Ionenstrahl schwenken zu können. Hierdurch kann das Substrat mit unterschiedlichem Beschichtungsmaterial beschichtet werden.

Aufgabe der Erfindung ist es, eine Beschichtungsanlage sowie ein Verfahren zur Beschichtung eines Substrates nach dem Ionen-Sputter-Verfahren zu schaffen, mit der bzw. mit dem auf einfache Weise eine möglichst gleichmäßige Beschichtung des Substrats erfolgen kann.

Die Lösung der Aufgabe erfolgt erfindungsgemäß durch die Merkmale des Anspruchs 1 bzw. 14.

Die erfindungsgemäße Beschichtungsanlage zur Beschichtung eines Substrats nach dem Ionen-Sputter-Verfahren weist in einer Vakuumkammer ein Halteelement auf, das mindestens ein Beschichtungselement trägt. Eine Ionenquelle ist auf das Beschichtungselement gerichtet, um Beschichtungsmaterial zur Beschichtung des Substrats abzutragen. Erfindungsgemäß ist das das Beschichtungselement tragende Halteelement mit einer Bewegungs- bzw. Schwenkeinrichtung, insbesondere einem Elektromotor mit gegebenenfalls zwischengeschaltetem Getriebe verbunden. Durch die Schwenkeinrichtung ist ein Bewegen des Halteelements und somit des Beschichtungselements in dem Ionenstrahl bzw. relativ zu dem Ionenstrahl möglich. Der Auftreffwinkel und/ oder der Auftreffpunkt des Ionenstrahls auf dem Beschichtungsmaterial kann hierdurch variiert werden. Dies führt einerseits gegebenenfalls zu einem großflächigeren Abtragen des Materials und andererseits zu einer Veränderung des Abstrahlwinkels des Beschichtungsmaterials. Hierdurch kann auf einfache Weise eine Vergleichmäßigung der Schichtdicke auf dem Substrat erzielt werden. Mit Hilfe der Steuereinrichtung, durch die insbesondere ein Hin- und Herschwenken des Halteelements während des Abtragens von Beschichtungsmaterial möglich ist, ist somit erfindungsgemäß mit einer Steuereinrichtung zum Steuern eines Auslenkwinkels oder einer Schwenkfrequenz des Halteelements verbunden. Dies hat insbesondere den Vorteil, dass in einer besonders bevorzugten Ausführungsform die Ionenquelle stationär angeordnet sein kann. Ein technisch aufwendiges Schwenken der Ionenquelle zur Veränderung des Abstrahlwinkels des abgesputteten Materials ist nicht mehr erforderlich.

Das Vorsehen einer erfindungsgemäßen Bewegungs- bzw. Schwenkeinrichtung, durch die ein Bewegen, bzw. Hin- und Herschwenken des Halteelements möglich ist, entspricht somit einer Ausgleicheinrichtung zum Vergleichmäßigen der Schichtdicke auf dem Substrat. Eine weitere Möglichkeit zur Vergleichmäßigung der Schichtdicke kann zusätzlich zu dem erfindungsgemäßen Bewegen bzw. Verschwenken des Halteelements durch Verschieben des Substrats selbst und/oder durch Schwenken der Ionenquelle erfolgen. Erfindungsgemäß erfolgt gegebenenfalls zusätzlich zu den bekannten Ausgleichseinrichtungen eine Vergleichmäßigung der Schichtdicke durch ein Integrieren der Ausgleicheinrichtung in die Schwenkeinrichtung. Hierdurch ist es möglich, durch ein insbesondere geringfugiges Schwenken des Halteelements und somit des Beschichtungselements den Abstrahlwinkel des Beschichtungsmaterials zu verändern. Hierdurch kann, da der Beschichtungsmaterial-Strahl mit der höchsten Materialdichte sodann an unterschiedlichen Stellen des Substrats auftrifft, eine Vergleichmäßigung der Beschichtung erzielt werden. Die erfindungsgemäße Schwenkeinrichtung dient somit einerseits zum Verschwenken des Halteelements, um unterschiedliche Beschichtungselemente in den Ionenstrahl zu schwenken, und kann als Ausgleichseinrichtung andererseits zusätzlich, während Material von ein und dem selben Beschichtungselement abgetragen wird, durch relativ geringfügiges Verschwenken ein Vergleichmäßigen der Schichtdicke auf dem Substrat bewirken.

In einer besonders bevorzugten Ausführungsform ist somit die Schwenkeinrichtung mit einer Steuereinrichtung zum Steuern eines Auslenkwinkels und/ oder einer Schwenkfrequenz verbunden. Vorzugsweise ist die Steuereinrichtung mit der Ionenquelle bzw. einer Steuereinrichtung der Ionenquelle verbunden. Hierdurch ist es möglich, Einstellungen der Ionenquelle, wie beispielsweise deren Leistungen, deren Pulsrate etc. bei der Steuerung der Schwenkeinrichtung zu berücksichtigen.

Bei einer besonders bevorzugten Ausführungsform der Erfindung ist zusätzlich eine Schichtdicken-Messeinrichtung zur Messung der Schichtdicke auf dem Substrat vorgesehen. Hierbei kann es sich um eine insbesondere seitlich neben dem Substrat angeordnete Messeinrichtung handeln, die direkt oder indirekt die auf das Substrat aufgebrachte Schichtdicke misst. Vorzugsweise wird eine Messeinrichtung verwendet, die zusammen mit dem Substrat beschichtet wird, so dass die Ablagerungen auf der Messeinrichtung bzw. die auf der Messeinrichtung entstehende Schicht unmittelbar gemessen werden kann. Erfindungsgemäß ist die Schichtdicken-Messeinrichtung vorzugsweise mit der Steuereinrichtung verbunden, so dass die gemessene Schichtdicke unmittelbar von der Steuerung der Schwenkeinrichtung berücksichtigt werden kann. Dies ist insbesondere vorteilhaft, wenn mehrere Schichtdicken-Messeinrichtungen vorgesehen sind, so dass beispielsweise auf einfache Weise festgestellt werden kann, dass die Schichtdicke sich auf einer Seite des Substrats von der Schichtdicke auf einer anderen Seite des Substrats unterscheidet. Hierbei sind vorzugsweise mehrere, insbesondere zwei Schichtdicken-Messeinrichtungen vorgesehen, die einander gegenüberliegend seitlich neben dem Substrat angeordnet sind. Insbesondere bei einer Schwenkeinrichtung, die durch die Steuereinrichtung hin- und hergeschwenkt wird, sind die Schichtdicken-Messeinrichtungen in Schwenkrichtung seitlich neben dem Substrat angeordnet. Wenn das Halteelement beispielsweise um eine vertikale Achse geschwenkt wird, sind die beiden Schichtdicken-Messeinrichtungen bei dieser bevorzugten Ausführungsform somit horizontal neben dem Substrat angeordnet.

Die Anordnung der Schichtdicken-Messeinrichtung bzw. der Schichtdicken-Messeinrichtungen erfolgt vorzugsweise in unmittelbarer Nähe, d. h. in einem sehr geringen Abstand von beispielsweise wenigen Millimetern, um sicherzustellen, dass die Beschichtungen der Schichtdicken-Messeinrichtung tatsächlich der Beschichtung des Substrats im Randbereich entspricht.

Es ist besonders vorteilhaft, dass die Ionenquelle stationär angeordnet sein kann. Ein Verschwenken der Ionenquelle zur Vergleichmäßigung der Schichtdicke auf dem Substrat ist nicht mehr erforderlich. Es ist somit möglich, die Ionenquelle selbst, die relativ groß baut, in die Seitenwand der Vakuumkammer zu integrieren. Dies hat den Vorteil, dass die Vakuumkammer selbst kleiner ausgebildet werden kann. Hierdurch können die Kosten zum Betreiben, sowie zum Herstellen der Vakuumkammer reduziert werden. Das Halteelement, das die mindestens zwei Beschiclltungselemente trägt, weist vorzugsweise eine ebene Anlagefläche je βeschichtungselement auf. Das Beschichtungselement ist vorzugsweise derart mit dem Halteelement verbunden, dass eine insbesondere ebene Rückseite des Beschichtungselements an der ebenen Anlagefläche flächig anliegt. Hierdurch ist es möglich, das Beschichtungselement effektiv zu kühlen, da die Kühlung des Beschichtungselements durch eine Kühlung des Halteelements erfolgen kann. Vorzugsweise weist das Halteelement hierzu Kühlkanäle auf, durch die Kühlmedium geleitet werden kann.

Vorzugsweise weist die erfindungsgemäße Beschichtungsanlage ein Halteelement auf, das mindestens zwei Beschichtungselemente trägt, bei denen es sich insbesondere um Beschichtungselemente aus unterschiedlichem Material handeln kann. Das jeweils gewünschte Beschichtungselement kann erfindungsgemäß in den Ionenstrahl geschwenkt werden. Erfindungsgemäß ist die Halterung, die die Beschichtungselemente trägt somit schwenkbar ausgebildet. Das Schwenken des Halteelements, um unterschiedliche Beschichtungselemente in den Ionenstrahl zu schwenken, erfolgt vorzugsweise mit Hilfe der vorstehend beschriebenen Schwenkeinrichtung. Durch das Vorsehen eines schwenkbaren Halteelements, das mindestens zwei Beschichtungselemente trägt, ist es möglich, auf kleinem Bauraum unterschiedliche Beschichtungselemente anzuordnen. Dies hat den Vorteil, dass das Volumen der Vakuumkammer nicht oder nur geringfügig vergrößert werden muss, um mehrere Beschichtungselemente in der Vakuumkammer anordnen zu können. Eine nennenswert größere und damit sowohl im Betrieb als auch in der Herstellung teurere Vakuumkammer ist somit bei dem Vorsehen des erfindungsgemäßen, schwenkbaren Halteelements nicht erforderlich.

Das Halteelement ist vorzugsweise mit einer Schwenkeinrichtung, die insbesondere einen Elektromotor aufweist, verbunden. Hierbei sind die Beschichtungselemente vorzugsweise in einem Winkel ungleich null zueinander angeordnet. Die Beschichtungselemente sind somit in unterschiedlichen Ebenen angeordnet, die vorzugsweise im Wesentlichen vertikal verlaufen. Insbesondere sind die Beschichtungselemente parallel zu einer Schwenkachse, um die das Halteelement schwenkbar ist, angeordnet.

Besonders bevorzugt ist es, dass das Halteelement zur lagegenauen Aufnahme der Beschichtungselemente je Beschichtungselement eine Vertiefung aufweist, in die das Beschichtungselement eingesetzt werden kann. Hierbei ist die ebene Anlagefläche insbesondere die Grundfläche der Vertiefung.

Die Befestigung der Beschichtungselemente erfolgt vorzugsweise über mindestens ein Halteelement je Beschichtungselement. Das vorzugsweise aus Titan hergestellte Halteelement ist vorzugsweise rahmenförmig ausgebildet, so dass das entsprechende Beschichtungselement an dem Rand gehalten ist. Eine Herstellung des Haltelements aus Titan hat den Vorteil, dass auch beim Auftreffen einzelner Ionen auf dem Halteelement die Gefahr des Herauslösens von Titanmaterial äußerst gering ist. Zur besseren Wärmeabfuhr und zur Vermeidung von Spannungsrissen werden empfindliche Beschichtungselemente vorzugsweise auf Kupfer-Rückplatten gebondet.

Ferner betrifft die Erfindung ein Verfahren zur Beschichtung eines Substrats nach dem lonen-Sputter-Verfahren. Zur Durchführung des Verfahrens ist es besonders bevorzugt, die vorstehend beschriebene Beschichtungsanlage zu verwenden. Gemäß des erfindungsgemäßen Verfahrens wird in einer Vakuumkammer ein Substrat angeordnet und mit Beschichtungsmaterial beschichtet. Das Beschichtungsmaterial wird von einem Beschichtungsmittel mittels eines Ionenstrahls durch Sputtern abgetragen. Erfindungsgemäß erfolgt zur Vergleichmäßigung der Schichtdicke auf dem zu beschichtenden Substrat ein Bewegen des Beschichtungsmaterials. Insbesondere erfolgt ein Hin- und Herschwenken des Beschichtungsmaterials. Vorzugsweise ist sodann eine stationäre Ionenquelle vorgesehen.

Bei einer besonders bevorzugten Ausführungsform des Verfahrens erfolgt ein Steuern der Bewegung bzw. des Schwenkens des Beschichtungsmaterials in Abhängigkeit der auf dem Substrat vorhandenen Schichtdicke. Diese wird hierbei vorzugsweise mittels einer Schichtdicken-Messeinrichtung gemessen. Hierbei erfolgt die Messung der auf dem Substrat vorhandenen Schichtdicke vorzugsweise mittelbar oder unmittelbar.

Das erfindungsgemäße Verfahren ist vorzugsweise wie anhand der beschriebenen Beschichtungsanlage erläutert, vorteilhaft weitergebildet.

Nachfolgend wird die Erfindung anhand einer bevorzugten Ausführungsform unter Bezugnahme auf die anliegenden Zeichnungen näher erläutert.

Es zeigen:
- Fig. 1: eine schematische Draufsicht auf eine Beschichtungsanlage gemäß der Erfindung,
- Fig. 2: eine schematische, perspektivische Ansicht einer bevorzugten Ausführungsform des Halteelements, und

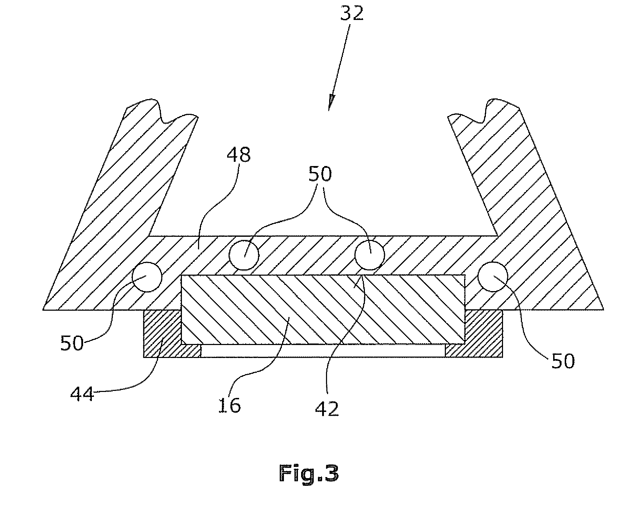

- Fig. 3: eine schematische Teil-Schnittansicht des Halteelements

Die erfindungsgemäße Beschichtungsanlage weist eine Vakuumkammer 10 auf, in der über nicht dargestellte Vakuumpumpen Vakuum erzeugt wird. Mit Hilfe einer Ionenquelle 12 wird ein Ionenstrahl 14 erzeugt, der auf ein Beschichtungselement bzw. Target 16 gerichtet ist. Durch den Ionenstrahl 14 werden aus dem Beschichtungselement 16 Partikel des Beschichtungsmaterials herausgebrochen. Durch dieses Sputtern wird ein insbesondere keulenförmiger Beschichtungsmaterial-Strahl 18 erzeugt. Das Beschichtungsmaterial 18 trifft auf eine Oberfläche 20 eines zu beschichtenden Substrats 22. Insbesondere zu Beginn des Beschichtungsverfahrens kann vor dem Substrat 22 eine Blende 25 angeordnet sein. Die Blende kann aus dem Materialstrahl 18 um eine Achse 26 in Richtung eines Pfeils 28 herausgeschwenkt werden. Das Substrat 22 wird von einem Substrathalter 24 gehalten.

Das Substrat 22 kann mittels der Substrathalterung 24 in Richtung eines Pfeils 30 sowie senkrecht zu diesem und senkrecht zur Zeichenebene verschoben werden. Ferner ist das Substrat 22 um eine Achse 51 in Richtung eines Pfeils 50 drehbar. Hierdurch kann ein Vergleichmäßigen des Materialauftrags auf dem Substrat 22 gewährleistet werden. In einer bevorzugten Ausführungsform ist dies wie nachstehend erläutert jedoch nicht erforderlich, sondern lediglich eine zusätzliche Option.

Ebenso ist es möglich, eine verschwenkbare Ionenquelle 12 vorzusehen, um die Lage des Ionenstrahls 14 sowie des hierdurch erzeugten Beschichtungsmaterial-Strahls 18 zu verändern. Dies ist jedoch lediglich eine Option, die in bevorzugter Ausführungsform der Erfindung nicht erforderlich ist.

Erfindungsgemäß ist eine Halteelement 32 zur Aufnahme unterschiedlicher Beschichtungselemente 16 vorgesehen. Das Halteelement 32 ist um eine Achse 34 in Richtung des Pfeils 36 schwenkbar. Durch das Schwenken des Halteelements 32 können unterschiedliche Targets 16 in den Ionenstrahl 14 geschwenkt werden.

Das Schwenken erfolgt vorzugsweise durch eine, mit der Halteeinrichtung verbundene Schwenkeinrichtung 33. Vorzugsweise ist die Schwenkeinrichtung 33 hierbei derart ausgebildet, dass ein Schwenken um kleine Winkel möglich ist. Hierdurch ist es möglich, die Schwenkeinrichtung 33 zusätzlich als Ausgleichseinrichtung zu nutzen. Durch ein geringfügiges Ändern der Lage des Beschichtungselements 16 verändert sich die Lage des Beschichtungsmaterial-Strahls 18. Hierdurch ist ein Vergleichmäßigen der Schichtdicke möglich.

Vorzugsweise kann das Halteelement 32 zusätzlich gekippt werden. Das Kippen erfolgt hierbei vorzugsweise um eine in der Zeichenebene liegende, beispielsweise senkrecht zur Schwenkachse 34 angeordneten Achse. Hierdurch kann ein Verkippen des Beschichtungsmaterial-Strahls aus der Zeichenebene heraus bzw. in die Zeichenebene herein erfolgen. Die Ausgleichseinrichtung, die in besonders bevorzugter Ausführungsform in die Schwenkeinrichtung integriert ist, bzw. durch die Schwenkeinrichtung selbst realisiert ist, ist vorzugsweise somit derart ausgebildet, dass die Lage des Beschichtungselements von dem das Material abgetragen wird, durch die im Raum vorgegebenen Grenzen frei einstellbar ist. Hierdurch kann ein äußerst exakter Ausgleich der Schichtdicke auf dem Substrat 22 erzielt werden. Ein derartiges Verkippen des Halteelements 32 ist bei einem um die Achse 51 rotierenden Substrat 22 nicht erforderlich,

Die Schwenkeinrichtung 33, die vorzugsweise einen Elektromotor und gegebenenfalls ein Getriebe aufweist, ist mit einer Steuereinrichtung 35 verbunden. Durch die Steuereinrichtung erfolgt ein Bewegen, insbesondere ein Hin- und Herschwenken des Halteelements 32, um eine Vergleichmäßigung der auf dem Substrat 22 vorhandenen Schicht 39 zu erreichen. Hierzu erfolgt ein Bewegen, insbesondere Hin- und Herschwenken des Halteelements 32, um einen durch die Steuereinrichtung 35 vorgegebenen Auslenkwinkel und/ oder in einer ebenfalls von der Steuereinrichtung 35 vorgegebene Schwenkfrequenz.

Die Steuereinrichtung 35 ist ferner über elektrische Leitungen mit Schichtdicken-Messeinrichtungen 37 verbunden. Im dargestellten Ausführungsbeispiel sind zwei Schichtdicken-Messeinrichtungen 37 vorgesehen, die seitlich neben dem Substrat 22 angeordnet sind. Auf einer Oberseite der Schichtdicken-Messeinrichtung 37 erfolgt ebenfalls ein Ablagern des Beschichtungsmaterials in Form von Schichten 39. Die Dicke der Schichten 39 entspricht der Dicke der Schicht 39 des Substrats 22 im Randbereich und kann durch die Messeinrichtungen 37 bestimmt werden. Die Messergebnisse können von der Steuereinrichtung 35 verarbeitet und bei der Steuerung der Bewegung des Halteelements 32 berücksichtigt werden.

Zusätzlich kann die Steuereinrichtung 35 mit der Ionenquelle 12 über eine elektrische Leitung verbunden sein, um beispielsweise Einstellungen der Ionenquelle bei der Steuerung des Bewegungsvorgangs berücksichtigen zu können.

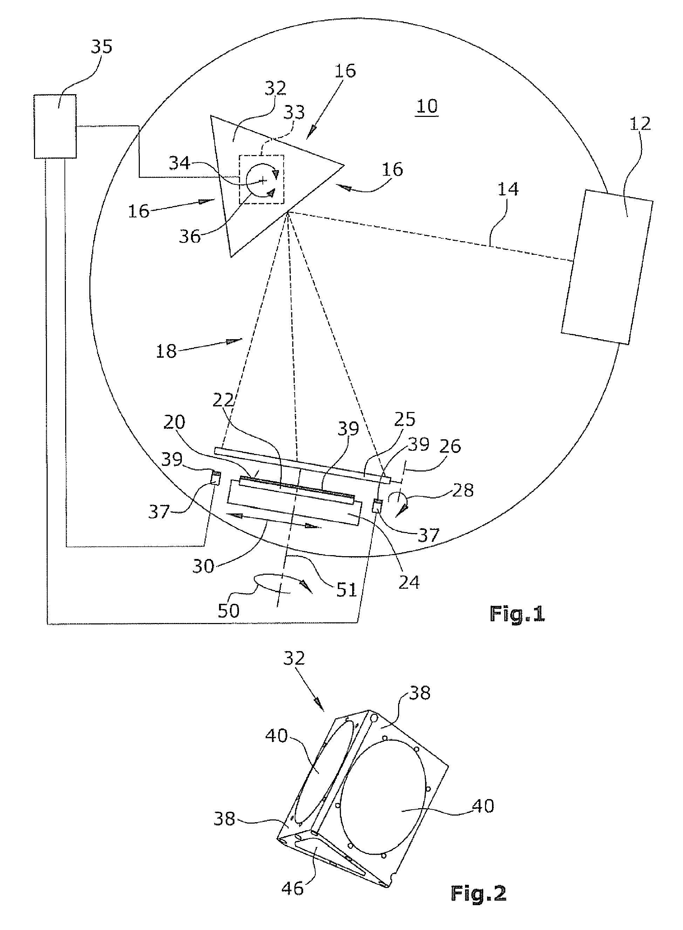

Eine besonders bevorzugte Ausführungsform des Halteelements 32 ist in Fig. 2 dargestellt. Hieraus ist ersichtlich, dass es sich bei dem Halteelement 32 um ein im Querschnitt gleichschenkliges Dreieck handelt. Zur Aufnahme von Beschichtungselementen 16 weist das Halteelement an jeder Außenseite 38 eine kreisrunde oder ovale Vertiefung 40 auf. Die Vertiefung 40 weist eine ebene Anlagefläche 42 auf. An der ebenen Anlagefläche 42 liegt das Beschichtungselement 16 an. Das Beschichtungselement 16 ist durch ein rahmenförmiges Halteteil 44, das insbesondere aus Titan hergestellt ist, gehalten.

Um eine gute Wärmeabfuhr von den Beschichtungsefernenten 16 zu gewährleisten, ist das Halteelement als Hohlkörper ausgebildet und weist insbesondere einen sich parallel zur Schwenkachse 34 erstreckenden durchgehenden Hohlraum 46 auf. Zur Verbesserung der Kühlung können in den Wandungen 48 des Halteelements 32 Kühlkanäle 50 vorgesehen sein.

## Patentansprüche

1. Beschichtungsanlage zur Beschichtung eines Substrats (22) nach dem lonen-Sputter-Verfahren, mit
einer Vakuumkammer (10) in der das zu beschichtende Substrat (22) angeordnet ist,
einem von einem Halteelement (32) getragenen, in der Vakuumkammer (10) angeordneten Beschichtungselement (16), und
einer Ionenquelle (12) zur Erzeugung eines auf das Beschichtungselement (16) lenkbaren Ionenstrahls (14), wobei durch den Ionenstrahl (14) Beschichtungsmaterial von dem Beschichtungselement (16) zur Beschichtung des Substrats (22) abgetragen wird,
**gekennzeichnet durch**,
eine mit dem Halteelement (32) verbundene Bewegungs- bzw. Schwenkeinrichtung (33) zum Bewegen bzw. Hin- und Herschwenken des Halteelements (32) während des Auftragens von Beschichtungsmaterial und
einer mit der Bewegungs- bzw. Schwenkeinrichtung (33) verbundenen Steuereinrichtung (35) zum Steuern eines Auslenkwinkels und/ oder einer Schwenkfrequenz des Halteelements (32).

2. Beschichtungsanlage nach Anspruch 1, **dadurch gekennzeichnet, dass** die Steuereinrichtung (35) mit der Ionenquelle (12) verbunden ist, so dass Einstellungen der Ionenquelle (12) bei der Steuerung berücksichtigbar sind.

3. Beschichtungsanlage nach Anspruch 1 oder 2, **gekennzeichnet durch** mindestens eine Schichtdicken-Messeinrichtung (37) zur Messung der Schichtdicke auf dem Substrat (22), wobei die Schichtdicken-Messeinrichtung (37) mit der Steuereinrichtung (35) verbunden ist.

4. Beschichtungsanlage nach Anspruch 3, **dadurch gekennzeichnet, dass** mehrere, insbesondere zwei Schichtdicken-Messeinrichtungen (37) vorgesehen sind.

5. Beschichtungsanlage nach Anspruch 3 oder 4, **dadurch gekennzeichnet, dass** die Schichtdicken-Messeinrichtungen (37) in Schwenkrichtung (36) seitlich neben dem Substrat (22) angeordnet sind,

6. Beschichtungsanlage nach einem der Ansprüche 1 - 5, **dadurch gekennzeichnet, dass** das Halteelement (32) mindestens zwei Beschichtungselemente (16) trägt und zum Anordnen jeweils eines der Beschichtungselemente (16) in den Ionenstrahl (14), insbesondere mittels der Schwenkeinrichtung (33) schwenkbar ist.

7. Beschichtungsanlage nach Anspruch 6, **dadurch gekennzeichnet, dass** die Beschichtungselemente (16) in einem Winkel ungleich Null zueinander mit dem Halteelement verbunden sind.

8. Beschichtungsanlage nach Anspruch 6 oder 7, **dadurch gekennzeichnet, dass** die Beschichtungselemente (16) parallel zu einer Schwenkachse (34), die um das Halteelement (32) schwenkbar ist, angeordnet sind.

9. Beschichtungsanlage nach Anspruch 7 oder 8, **dadurch gekennzeichnet, dass** das Halteelement (32) je Beschichtungselement (16) eine Vertiefung (40) zur Aufnahme aufweist.

10. Beschichtungsanlage nach Anspruch 9, **dadurch gekennzeichnet, dass** die Vertiefung (40) ein ebene Anlagefläche (42) zum flächigen Anliegen des Beschichtungselements (16) aufweist,

11. Beschichtungsanlage nach einem der Ansprüche 7 bis 10, **dadurch gekennzeichnet, dass** das Halteelement (32) je Beschichtungselement (16) mindestens ein, vorzugsweise rahmenförmiges Halteteil (44) aufweist.

12. Beschichtungsanlage nach einem der Ansprüche 7 bis 11, **dadurch gekennzeichnet, dass** das Halteelement (32) zur Hindurchleitung von Kühlmedium Kühlkanäle (50) aufweist.

13. Beschichtungsanlage nach einem der Ansprüche 1 bis 12, **dadurch gekennzeichnet, dass** die Ionenquelle (12) stationär ist.

14. Verfahren zur Beschichtung eines Substrats (22) nach dem Ionen-Sputter-Verfahren, insbesondere mittels einer Beschichtungsanlage nach einem der Ansprüche 1 bis 13, bei welchem
ein in einer Vakuumkammer (10) angeordnetes Substrat (22) mit Beschichtungsmaterial beschichtet wird, das von einem Beschichtungselement (16) mittels eines Ionenstrahls (14) abgetragen wird,
wobei zur Vergleichmäßigung der Schichtdicke auf dem Substrat (22) das Beschichtungselement (16) bewegt, insbesondere hin- und hergeschwenkt wird.

15. Verfahren nach Anspruch 14, bei welchem ein Steuern der Bewegung, insbesondere des Schwenkens in Abhängigkeit einer, insbesondere mittels einer Schichtdicken-Messeinrichtung (37) gemessenen auf dem Substrat (22) vorhandenen Schichtdicke erfolgt.
